# EUROPEAN PATENT APPLICATION

(11) **EP 4 322 712 A1**
(43) Date of publication of application: **14.02.2024**
(21) Application number: 22876625.9
(22) Date of filing: 27.06.2022
(51) Int. Cl.: H05K 1/09, B32B 15/01, H05K 3/00, H05K 3/10, H05K 3/06

(54) **CARRIER-FOIL-ATTACHED ULTRA-THIN COPPER FOIL AND METHOD FOR MANUFACTURING EMBEDDED SUBSTRATE USING SAME**

(30) Priority: 30.09.2021 KR 20210130381
(71) Applicant: LOTTE ENERGY MATERIALS CORPORATION, Iksan-si, Jeollabuk-do 54586 (KR)
(72) Inventor: YANG, Chang Yol, Iksan-si Jeollabuk-do 54586 (KR); BEOM, Won Jin, Iksan-si Jeollabuk-do 54586 (KR); KIM, Hyung Cheol, Iksan-si Jeollabuk-do 54586 (KR); SONG, Kideok, Iksan-si Jeollabuk-do 54586 (KR)
(74) Representative: Mammel und Maser Patentanwälte PartG mbB
(86) International application number: PCT/KR2022/009123
(87) International publication number: WO 2023/054850

(57) **Abstract**

The present invention relates to a carrier-foil-attached ultra-thin copper foil and a method for manufacturing an embedded substrate using same. The carrier-foil-attached ultra-thin copper foil according to the present invention comprises a carrier foil, a non-etched delamination layer on the carrier foil, a first ultra-thin copper foil layer on the non-etched delamination layer, an etching stop layer on the first ultra-thin copper foil layer, and a second ultra-thin copper foil layer on the etching stop layer.

## Description

### BACKGROUND OF THE INVENTION

### 1. Field of the invention

The present disclosure relates to an ultra-thin copper foil with a carrier foil and an embedded substrate manufactured using the same and, particularly, to an ultra-thin copper foil with a carrier foil, which provides an excellent smooth ultra-thin copper foil having low roughness for embedded trace substrate (ETS) techniques.

### 2. Description of the Prior Art

Conventional ultra-thin copper foils with carrier foils for embedded substrates typically have a structure having a release layer and an ultra-thin copper foil that are formed on a carrier foil.

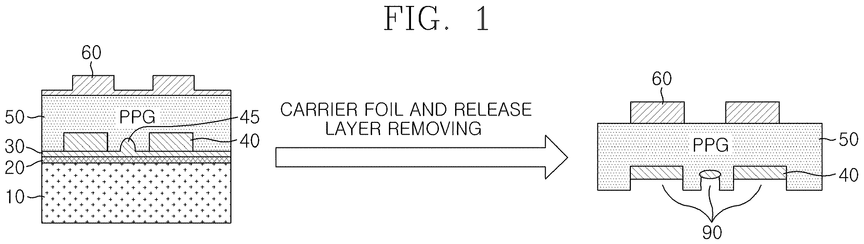

FIG. 1 is a diagram for showing a manufacturing process for an embedded substrate by using a conventional ultra-thin copper foil with a carrier foil.

Referring to FIG. 1, in the manufacturing of an embedded substrate using an ultra-thin copper foil with a carrier foil through a conventional embedded trace substrate (ETS) technique, the use of a structure having a release layer 20 and an ultra-thin copper foil 30 formed on a substrate 10 may generate an undesired bump 45 during the formation of metal patterns 40 due to the insufficient surface roughness. A prepreg (PPG) 50 is formed, and different metal patterns 60 can be further formed thereon. In the procedure of removing the substrate 10 and the release layer 20 after the formation of the metal patterns 40 and the prepreg 50, the release layer 20 needs to be sufficiently etched in order to eliminate a defective element, such as the nodule 45, but delicate etching control is not easy and the metal patterns 40 are formed inside the prepreg 50, causing a defect with respect to recess depth 90, which results in a disconnection or short circuit in circuit metal patterns.

Patent Application No. 10-2009-0081909 (1 September 2009), Patent Application No. 10-2020-7001958 (18 October 2018), and the like may be referred to as related prior art.

### SUMMARY OF THE INVENTION

Therefore, the present disclosure has been derived to solve the above-described problems, and an aspect of the present disclosure is to provide an ultra-thin copper foil with a carrier foil, wherein by using an ultra-thin copper foil with a carrier foil including a selectively etchable Ni etch stop layer between two ultra-thin copper foil layers, a seed ultra-thin copper foil layer can be provided as a low-roughness seed ultra-thin copper foil layer to suppress nodulation in the manufacturing process of an embedded substrate.

Another aspect of the present disclosure is to provide a method for manufacturing an embedded substrate, wherein the manufacturing of the embedded substrate is ended by a releasing process of removing a Ni etch stop layer and the etching of the etch stop layer is precisely performed, thereby causing no recess depth between a metal pattern surface and an insulation layer such as a prepreg and providing an excellent smooth surface with low roughness as a release surface.

In accordance with an aspect of the present disclosure, there is provided an ultra-thin copper foil with a carrier foil, including: a carrier foil; a non-etching release layer on the carrier foil; a first ultra-thin copper foil layer on the non-etching release layer; an etch stop layer on the first ultra-thin copper foil layer; and a second ultra-thin copper foil layer on the etch stop layer.

The etch stop layer may have an average roughness Rz of 1.5 um or less or 0.5 µm or less.

The second ultra-thin copper foil layer may have an average roughness Rz of 1.5 um or less or 0.6 um or less.

The etch stop layer may be a nickel or nickel alloy layer.

The first ultra-thin copper foil layer may have a thickness of 5 µm or less, the etch stop layer may have a thickness of 1 µm or less, and the second ultra-thin copper foil layer may have a thickness of 5 µm or less.

The etch stop layer may be inert to an etchant for the second ultra-thin copper foil layer.

The non-etching release layer may contain an inorganic metal or an organic material.

The non-etching release layer may be composed of an alloy containing a first metal having releasability and at least one metal that assists the facilitation of plating of the first metal. The non-etching release layer may further include an anti-diffusion layer or anti-oxidation layer containing at least one element selected from the group consisting of Ni, Co, Fe, Cr, Mo, W, Al, and P.

In accordance with an aspect of the present disclosure, there is provided a method for manufacturing an embedded substrate, the method including: forming, as for a structure in which a non-etching release layer, a first ultra-thin copper foil layer, an etch stop layer, and a second ultra-thin copper foil layer are sequentially laminated on a carrier foil, first metal patterns on the second ultra-thin copper foil layer of the structure; etching a portion of the second ultra-thin copper foil layer, exposed between the first metal patterns; forming a first dielectric layer on the first metal patterns; removing the non-etching release layer and the carrier foil from the structure with the first dielectric layer formed therein; etching to remove the first ultra-thin copper foil layer exposed by the removal of the non-etching release layer and the carrier foil; and etching to remove the etch stop layer exposed after the removal of the first ultra-thin copper foil layer.

In the removing of the first ultra-thin copper foil layer, an etchant having high etch selectivity to the first ultra-thin copper foil layer may be used.

In the removing of the etch stop layer, an etchant having high etch selectivity to the etch stop layer may be used.

According to the ultra-thin copper foil with a carrier foil and the method for manufacturing an embedded substrate by using the same, an ultra-thin copper foil with a carrier foil can be provided including a selectively etchable Ni etch stop layer between two ultra-thin copper foil layers, and thus a seed ultra-thin copper foil layer can be provided as a low-roughness seed ultra-thin copper foil layer to suppress nodulation in the manufacturing process of an embedded substrate. Therefore, in the manufacturing of an embedded substrate, an ultra-thin copper foil with a carrier foil can be provided that is very suitable as a copper foil for a microcircuit board due to overall excellence in terms of requirement characteristics as a copper foil, such as peel strength, heat-resistant peel strength, chemical resistance, and etchability.

Furthermore, according to the ultra-thin copper foil with a carrier foil and the method for manufacturing an embedded substrate by using the same according to the present disclosure, the manufacturing of the embedded substrate is ended by a releasing process of removing a Ni etch stop layer and the etching of the etch stop layer is precisely performed, thereby causing no recess depth between the metal pattern surface and an insulation layer such as a prepreg and providing an excellent smooth surface with low roughness as a release surface. Therefore, causes of defects, such as a disconnection or short circuit, in circuit metal patterns can be eliminated, and thus the formation of circuits is excellent.

### BRIEF DESCRIPTION OF THE DRAWINGS

The accompanying drawings, which are included as a part of the description to help the understanding of the disclosure, provide embodiments of the disclosure and, together with the description, explain the technical spirit of the disclosure.
FIG. 1 is a diagram for illustrating a method for manufacturing an embedded substrate by using a conventional ultra-thin copper foil with a carrier foil.
FIG. 2 is a diagram for illustrating an ultra-thin copper foil with a carrier foil according to an embodiment of the present disclosure.
FIG. 3 is a process flowchart for illustrating a method for manufacturing an embedded substrate by using an ultra-thin copper foil with a carrier foil 1000 according to an embodiment of the present disclosure.
FIGS 4A to 4C are SEM images of plating surfaces observed in the manufacturing process of a sample manufactured according to an example of the present disclosure.
FIGS 5A and 5B are SEM images of plating surfaces observed in the manufacturing process of a sample manufactured according to a comparative example of the present disclosure.

### DETAILED DESCRIPTION OF THE EXEMPLARY EMBODIMENTS

Hereinafter, the present disclosure will be described in detail with reference to the accompanying drawings. In each drawing, like components are denoted by like reference numerals. Further, the detailed description of known functions and/or components will be omitted. The following disclosed contents mainly describe portions required to understand operations according to embodiments and the description of elements which make the gist of the description obscure will be omitted. Further, some of components of the drawings may be exaggerated, omitted, or schematically illustrated. A size of each component does not completely reflect a real size and therefore the contents disclosed herein are not limited by a relative size or interval of the components illustrated in the drawings.

When describing exemplary embodiments of the disclosure, when it is determined that a detailed description with respect to known technology related to the disclosure may unnecessarily obscure a gist of the present disclosure, a detailed description thereof will be omitted. The terminology used hereinafter is terms defined by considering a function in exemplary embodiments of the disclosure, and their meaning may be changed according to intentions of a user and an operator, customs, or the like. Accordingly, the terminology will be defined based on the contents throughout this specification. The terminology used in the detailed description is used for describing exemplary embodiments of the disclosure, and is not used for limiting the disclosure. Elements of the disclosure in the singular may number one or more, unless the context clearly indicates otherwise. It will be further understood that the terms "comprise", "comprising", "includes", and/or "including", when used herein, specify the presence of stated features, items, steps, operations, elements, and/or components, but do not preclude the presence or addition of one or more other features, items, steps, operations, elements, components, and/or groups thereof.

As used herein, the term "lamination" refers to binding of at least two layers. For example, the lamination of a first layer and a second layer includes not only a direct contact of the first and second layers but also binding of an additional third layer interposed between the first and second layers.

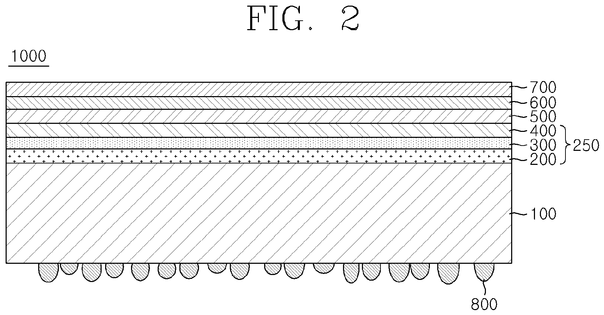

FIG. 2 is a diagram for illustrating an ultra-thin copper foil with a carrier foil 1000 according to an embodiment of the present disclosure.

Referring to FIG. 2, the ultra-thin copper foil with a carrier foil 1000 according to an embodiment of the present disclosure includes a carrier foil 100, a non-etching release layer 250 on the carrier foil 100, a first ultra-thin copper foil layer 500 on the non-etching release layer 250, an etch stop layer 600 on the first ultra-thin copper foil layer 500, and a second ultra-thin copper foil layer 700 as a seed layer on the etch stop layer 600.

In the present disclosure, the thickness of the carrier foil 100 may be several tens of µm, and for example, 10-100 µm. The roughness of a matte side (M side) or a shiny side (S side) of the carrier foil 100 may be 4.0 times or less, and preferably, 0.5-4.0 times the roughness of the second ultra-thin copper foil layer 700. The thicknesses of the first ultra-thin copper foil layer 500, etch stop layer 600, and second ultra-thin copper foil layer 700 are preferably 0.1-3 µm, 0.1-3 µm, and 0.1-5 µm, respectively. In the present disclosure, a nodulation layer 800 may be further formed on the bottom surface of the carrier foil 100.

In the present disclosure, the non-etching release layer 250 may be a release layer 300 alone, or may further include at least one additional layer above or below the release layer 300, for example, may further include an anti-diffusion layer 200 and an anti-oxidant layer 400 shown in FIG. 2.

In the present disclosure, the release layer 300 is a layer for improving releasability when the carrier foil is released from the ultra-thin copper foil, and the release layer 300 is introduced to release the carrier foil clearly and easily. In the present disclosure, the release layer may contain a metal or metal alloy having releasability. The releasable metal may include molybdenum or tungsten.

In the present disclosure, when the release layer 300 contains an inorganic metal, the release layer may be composed of an alloy containing a first metal (e.g., Mo, W, etc.) having releasability and at least one metal (e.g., Fe, Co, Ni, etc.) that assists the facilitation of plating of the first metal.

For example, the release layer 300 may be formed by plating of a Mo-Ni-Fe alloy, wherein the plating amount is preferably 50-10000 µg/dm².

When the release layer 300 contains an inorganic material, the release layer may be formed using one or more organic agents selected from a nitrogen-containing organic compound, a sulfur-containing organic compound, and a carboxylic acid, so as to have releasability. 1,2,3-Benzotriazole, carboxybenzotriazole, or the like may be used as a nitrogen-containing organic compound, and mercaptobenzothiazole, thiocyanuric acid, or the like may be used as a sulfur-containing organic compound. In addition, oleic acid, linoleic acid, or the like may be used as a carboxylic acid.

The non-etching release layer 250 may further include at least one layer of an anti-diffusion layer 200 or an anti-oxidation layer 400 above and below the release layer 300.

In the present disclosure, the anti-diffusion layer 200 and the anti-oxidation layer 400 may be formed by plating. The anti-diffusion layer 200 and the anti-oxidation layer 400 suppress the diffusion of copper into the release layer in a high-temperature process in which the ultra-thin copper foil with a carrier foil is pressed to an insulating substrate at a high temperature. The diffusion of copper into the release layer may generate metallic binding between the carrier foil and the ultra-thin copper foil and the strong binding strength therebetween may make the release of the carrier foil difficult, but the anti-diffusion layer 200 and the anti-oxidation layer 400 can suppress such reaction. The anti-diffusion layer 200 and the anti-oxidation layer 400 may be a single metal layer or may be an alloy layer of two or more metals. For example, a nickel plating, a cobalt plating, an iron plating, an aluminum plating, or the like may be used as a plating for forming a single metal layer, and a nickel-cobalt plating, a nickel-iron plating, a nickel-chromium plating, a nickel-molybdenum plating, a nickel-tungsten plating, a nickel-copper plating, a nickel-phosphorus plating, a cobalt-iron plating, a cobalt-chromium plating, a cobalt-molybdenum plating, a cobalt-tungsten plating, a cobalt-copper plating, a cobalt-phosphorus plating, or the like may be used as a plating for forming a binary alloy layer. In the present disclosure, the anti-diffusion layer 200 and the anti-oxidation layer 400 may be for example a Ni-P plating.

In the present disclosure, the ultra-thin copper foil has a three-layer lamination structure in which the first ultra-thin copper foil layer 500, the etch stop layer 600, and the second ultra-thin copper foil layer 700 are sequentially laminated. In the present disclosure, the thickness of the ultra-thin copper foil including the first ultra-thin copper foil layer 500, the etch stop layer 600, and the second ultra-thin copper foil layer 700 may be 2-14 um. Preferably, the thickness of the ultra-thin copper foil may be 10 µm or less, 8 µm or less, or 6 µm or less.

In the present disclosure, the first ultra-thin copper foil layer 500 may have a thickness of 1-5 um. Preferably, the first ultra-thin copper foil layer 500 may have a thickness of 1.5-2 um.

In the present disclosure, the etch stop layer 600 may have low average roughness. For example, the etch stop layer 600 may have an average roughness (Rz) of 1 µm or less, 0.8 um or less, 0.6 um or less, or 0.5 um or less. Such a low average roughness (Rz) of the etch stop layer can lower the roughness of the ultra-thin copper foil formed thereon and suppress the formation of a nodulation structure on the surface of the ultra-thin copper foil. To this end, a plating process of Ni or a Ni alloy having high glossiness as described later may be applied.

In the present disclosure, the etch stop layer 600 may be formed of a metal or metal alloy, for example, a nickel (Ni) or nickel alloy layer, which is inert to an etchant for the first ultra-thin copper foil layer 500 and the second ultra-thin copper foil layer 700. Hence, in the etching process of the first ultra-thin copper foil layer 500 or the second ultra-thin copper foil layer 700, the first ultra-thin copper foil layer 500 and the second ultra-thin copper foil layer 700 have high etch selectivity compared with the etch stop layer 600. Conversely, in the etching process of the etch stop layer 600, the etch stop layer 600 has high etch selectivity compared with the first ultra-thin copper foil layer 500 and the second ultra-thin copper foil layer 700.

In the present disclosure, the etch stop layer 600 may have a thickness of 0.4-2 µm. Preferably, the etch stop layer 600 may have a thickness of 1 µm or less, 0.8 µm or less, or 0.6 um or less.

In the present disclosure, the second ultra-thin copper foil layer 700 may have a thickness of 1-5 um. Preferably, the second ultra-thin copper foil layer 700 may have a thickness of 1-3 um.

As described above, the present disclosure provides an ultra-thin copper foil with a carrier foil 1000 including a Ni/Ni alloy etch stop layer 600, which has high etch selectivity compared with copper or a copper alloy in a wet or dry etching process, between the two ultra-thin copper foil layers 500 and 700. In the present disclosure, the second ultra-thin copper foil layer 700 may have an average roughness (Rz) of 1.5 µm or less, 1.3 µm or less, 1.1 µm or less, 0.9 µm or less, 0.7 µm or less, or 0.6 µm or less.

Therefore, the etch stop layer 600 can be delicately etched in the manufacturing of an embedded substrate, so that the recess depth between the metal pattern surface and an insulating layer such as a prepreg is not needed, and an excellent smooth surface with low roughness can be provided. In the present disclosure, the second ultra-thin copper foil layer 700 with low roughness can suppress the bump (see FIG. 1) in the manufacturing of an embedded substrate. Therefore, causes of defects, such as a disconnection or short circuit, in circuit metal patterns can be eliminated in the formation of circuits.

In the present disclosure, the second ultra-thin copper foil layer 700 may be further surface-treated. For example, surface treatment, such as any one type of or a combination of heat resistance and chemical resistance treatment, chromate treatment, and silane coupling treatment, may be performed, and the type of surface treatment to be performed may be appropriately selected according to the subsequent process.

Heat resistance and chemical resistance treatment may be for example performed by forming a thin film on a metal foil by sputtering, electroplating, or electroless plating of any one or an alloy of nickel, tin, zinc, chromium, molybdenum, cobalt, and the like. Electroplating is preferable in view of cost.

As for chromate treatment, an aqueous solution containing hexavalent to trivalent chromium ions may be used. Chromate treatment may be performed by simple immersion treatment, but may be preferably performed by cathodic treatment. Chromate treatment is preferably performed under conditions of 0.1 to 70 g/L sodium dichromate, pH 1 to 13, a bath temperature of 15 to 60°C, a current density of 0.1 to 5 A/dm², an electrolysis time of 0.1 to 100 seconds. In addition, chromate treatment is preferably performed on anti-corrosion treatment, and thus can further improve moisture resistance and heat resistance.

Examples of a silane coupling agent used for silane coupling treatment are epoxy functional silanes, such as 3-glycidoxypropyl trimethoxysilane and 2-(3,4-epoxycyclohexyl)ethyltrimethoxysilane, amino functional silanes, olefin functional silanes, acrylic functional silanes, methacryl functional silanes, mercapto functional silanes, and the like, wherein these may be used alone or a plurality thereof may be mixed and used. Such a silane coupling agent is dissolved in a solvent such as water to a concentration of 0.1 to 15 g/L, and applied to a metal foil at room temperature to a temperature of 70°C or adsorbed thereon by electrodeposition. After silane coupling treatment, stable binding is formed by heating, ultraviolet radiation, or the like. As for heating, the silane coupling agent may be dried at a temperature of 100 to 200°C for 2 to 60 seconds.

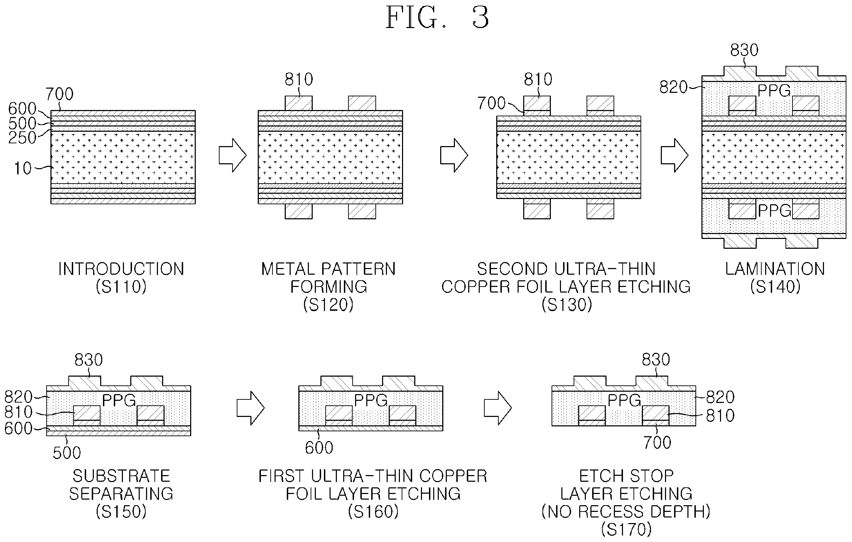

FIG. 3 is a process flowchart for illustrating an embedded trace substrate (ETS) method for manufacturing an embedded substrate by using an ultra-thin copper foil with a carrier foil according to an embodiment of the present disclosure.

Referring to FIG. 3, an ultra-thin copper foil with a carrier foil 1000 for manufacturing an embedded substrate is first prepared and introduced into a plating machine (S110). A structure in which the ultra-thin copper foil with a carrier foil 1000 is attached on a substrate 10 is introduced. For example, a substrate having adhesive properties may be used as the substrate. As shown, ultra-thin copper foil a with carrier foils 1000 may be attached to both surfaces of the substrate 10. The ultra-thin copper foil with a carrier foil 1000 has a structure, in which a non-etching release layer 250, a first ultra-thin copper foil layer 500, an etch stop layer 600, and a second ultra-thin copper foil layer 700 are sequentially laminated on a carrier foil 100, as shown in FIG. 2.

When the ultra-thin copper foil with a carrier foil together with the substrate 10 is introduced into the plating machine, first metal patterns 810 are formed on the second ultra-thin copper foil layer 700 by plating (S120). Although not described, the metal patterns 810 may be formed by various methods. For example, a predetermined plating resist pattern is formed on the second ultra-thin copper foil layer 700, and a plating layer is formed in an opening portion, followed by removal of the plating resist pattern, thereby forming the first metal patterns 180 by the plating layer.

Then, the second ultra-thin copper foil layer 700 is pattern-etched (S130). This step may be performed by various methods. For example, this step may be performed by an etch-back process, that is, dry etching or wet etching the second ultra-thin copper foil layer 700 through the first metal patterns 810 as an etching mask. Therefore, a portion of the second ultra-thin copper foil layer 700, which is located below the first metal patterns 810, is left and an exposed portion of the second ultra-thin copper foil layer 700 is removed. In the present disclosure, the patterning process of the second ultra-thin copper foil layer 700 has an advantage in that unintended bumps on the ultra-thin copper foil as descried with respect to FIG. 1 can be removed.

Then, an insulating or dielectric prepreg layer 820 is laminated on the structure thus formed (S140). A material, such as an epoxy resin, a polyimide, phenol, or bismaleimide triazine resin (BT), may be used for prepreg (PPG). Then, a second metal pattern 830 may be further formed on the prepreg layer 820 to manufacture a multilayer-structured substrate. Although not shown, a portion that is electrically connected through a via hole may be included between the first metal patterns 810 and the second metal pattern 830. For the multilayer-structured substrate, another prepreg layer (not shown), in addition to the second metal pattern 830, may be further formed on the second metal pattern 830. That is, a structure including a metal pattern and a prepreg layer may be repeatedly formed twice or more on the prepreg layer 820. The last layer of the structure can be a dielectric layer, and another metal pattern may also be formed on the last dielectric layer.

When the lamination structure including the prepreg layer 820 is formed as described above, the substrate 10 is removed. This removal may be performed by applying physical releasing using the non-etching release layer 250. During this separation process, the substrate 10 and the carrier foil 100 may be removed together with the removal of the non-etching release layer 250, and an ultra-thin copper film structure including the metal patterns and prepreg is separated (S150).

Then, the exposed first ultra-thin copper foil layer 500 is removed by etching, for example, wet etching (S160). The first ultra-thin copper foil layer 500 may be removed with an etchant, which has high etch selectivity to the first ultra-thin copper foil 500 compared with the etch stop layer 600. For example, as the etchant, commercially available CPE-800 used as a flash etchant or a dilution thereof may be used.

The exposed etch stop layer 600 may be removed by wet etching with an etchant, which has high etch selectivity to the exposed etch stop layer 600 compared with the second ultra-thin copper foil layer 700 (S170). Thus, the etching is stopped on the surface of the pattern of the second ultra-thin copper foil layer 700, and the surface of the patterns of the second ultra-thin foil 700 and the prepreg surface are positioned on the same plane. For example, a sulfuric acid solution or a mixture solution of sulfuric acid and nitric acid may be used as the etchant.

As such, in the present disclosure, the ultra-thin copper foil with a carrier foil 1000 including the Ni/Ni alloy etch stop layer 600, which can be selectively etched with respect to ultra-thin copper foil layers, between the two ultra-thin copper foil layers 500 and 700 is applied to an embedded trace substrate (ETS) method.

Therefore, in the manufacturing of an embedded substrate, the first ultra-thin copper foil layer 500 and the second ultra-thin copper foil layer 700 can be delicately etched by using the etch stop layer 600, and thus a recess depth is not needed in the final metal pattern. Additionally, the second ultra-thin copper foil layer 700 with low roughness can suppress nodulation (see FIG. 1) in the manufacturing of an embedded substrate, and unintended nodules formed on the surface of the second ultra-thin copper foil layer 700 can be removed in the pattern step (S130) of the second ultra-thin copper foil layer 700 for metal patterns.

### <Example 1>

An ultra-thin copper foil with a carrier foil was manufactured by the following method.

### A. Carrier foil

An electrolytic copper foil with a surface roughness of 1.2 µm and a thickness of 18 µm was used.

### B. Anti-diffusion layer

An anti-diffusion layer was formed on the carrier foil by the plating bath below.
- Ni concentration: 10-20 g/L, P concentration: 5-15 g/L
- pH 4.0, temperature: 30°C, current density: 1.5 A/dm2, plating time: 2 seconds
- The plating amount of the anti-diffusion layer 200 being a plating amount of metal (Ni) of 301 µg/dm²

### C. Release layer

A release layer was formed by a Mo-Ni-Fe plating bath.
- Mo concentration: 10-30g/L, Ni concentration: 3-10 g/L, Fe concentration: 1-5 g/L, sodium citrate: 100-200 g/L
- pH 10.2 (ammonia water 30ml/L being added), temperature: 30°C, current density: 10 A/dm2, plating time: 7 seconds
- The plating amount of the release layer 300 being 1.01 mg/dm2, the composition of the release layer being Mo 62.31 wt%, Ni 30.8 wt%, and Fe 6.89 wt%

### D. Anti-oxidation layer

A Ni plating was formed by the plating bath below.
- Ni concentration: 10-20 g/L, P concentration: 5-15 g/L
- pH 4.0, temperature: 30°C, current density: 0.5A/dm2, plating time: 2 seconds
- The plating amount of the anti-diffusion layer being a plating amount of a metal (Ni) of 30 µg/dm2

### E. First ultra-thin copper foil layer

An ultra-thin copper foil layer was formed by the plating bath below. The plating thickness was 2 µm.
- CuSO₄-5H₂O: 300g/L, H₂SO₄: 150g/L
- temperature: 35°C, current density: 20 A/dm2, plating time: 30 seconds

### F. Etch stop layer 600

An etch stop layer was formed by the Ni plating bath below. The thickness was 0.5 µm.
- Nickel sulfate: 300-500 g/L, boric acid: 20-40 g/L, saccharin: 1-5 g/L, sodium allyl sulfonic acid: 1-5 g/L
- Temperature: 60°C, current density: 20 A/dm2, plating time: 9 seconds

### G. Second ultra-thin copper foil layer

An ultra-thin copper foil layer was formed by the plating bath below. The plating thickness was 2 µm.
- CuSO4-5H2O: 300g/L, H2SO4: 150g/L
- temperature: 35°C, current density: 20A/dm2, plating time: 30 seconds

### H. Surface treatment

Heat resistance and chemical resistance treatment, chromate treatment, and silane coupling treatment were further performed on the second ultra-thin copper foil layer.

In the manufacturing procedure of the ultra-thin copper foil with a carrier foil sample, each layer was formed and then measured for surface roughness, and the nodules on the surface of the final plating were counted. The results are shown in Table 1.

The second ultra-thin copper foil layer of the ultra-thin copper foil with a carrier foil sample thus manufactured was selectively etched with PE-800 etchant diluted to 1/10, and then the exposed etch stop layer was selectively etched with a special sulfuric acid solution at 550-650 ml/l. As an etching result, excellent selectivity was shown between the etch stop layer and the ultra-thin copper foil layer.

### <Example 2>

An ultra-thin copper foil with a carrier foil was manufactured by the same method as in Example 1 except that an organic release layer was used as a release layer.

A release layer was formed by the plating bath below.
- carboxybenzotriazole concentration: 1-5 g/L, copper concentration: 5-15 g/L, H2SO4 concentration: 150 g/L
- temperature: 40°C, dipping time: 30 seconds

In the manufacturing procedure of the ultra-thin copper foil with a carrier foil sample, each layer was formed and then measured for surface roughness, and the nodules on the surface of the final plating were counted. The results are shown in Table 1.

### <Comparative Example 1>

An ultra-thin copper foil with a carrier foil was manufactured by the same method as in Example 1 except that the conditions of a plating bath for forming an etch stop layer were as follows. The thickness of the etch stop layer was 0.5 µm.
- nickel sulfamate 60%: 300-500 g/L, boric acid: 20-40 g/L
- temperature: 50°C, current density: 20 A/dm², plating time: 9 seconds

In the manufacturing procedure of the ultra-thin copper foil with a carrier foil sample, each layer was formed and then measured for surface roughness, and the nodules on the surface of the final plating were counted. The results are shown in Table 1.

### <Comparative Example 2>

A single ultra-thin copper foil layer was formed on an anti-oxidation layer without the formation of an etch stop layer. The thickness of the ultra-thin copper foil layer was 2 µm. The conditions of each plating were the same as in Example 1.

Table 1 below shows the results of measuring properties of the ultra-thin copper foil with a carrier foils manufactured in Examples 1 and 2 and Comparative Examples 1 and 2.

In the manufacturing procedure of the ultra-thin copper foil with a carrier foil sample, each layer was formed and then measured for surface roughness, and the nodules on the surface of the final plating were counted. The results are shown in Table 1.

**TABLE 1**

| | Carrier foil Rz | Release layer | Rz after plating of first ultra-thin copper foil layer | Nickel etch stop layer | Rz after plating of nickel etch stop layer | Rz after plating of second ultra-thin copper foil layer | Bump count (EA/ cm²) |
|---|---|---|---|---|---|---|---|
| Example 1 | Rz<1.2 | Inorganic release layer | 0.81 | 0.5 µm | 0.41 | 0.42 | 0 |
| Example 2 | Rz<1.2 | Organic release layer | 0.90 | 0.5 µm | 0.46 | 0.51 | 0 |
| Comparative Example 1 | Rz<1.2 | Inorganic release layer | 0.81 | 0.5 µm | 1.33 | 1.33 | 10-20 |
| Comparative Example 2 | Rz<1.2 | Inorganic release layer | 0.79 | X | | | 4-10 |

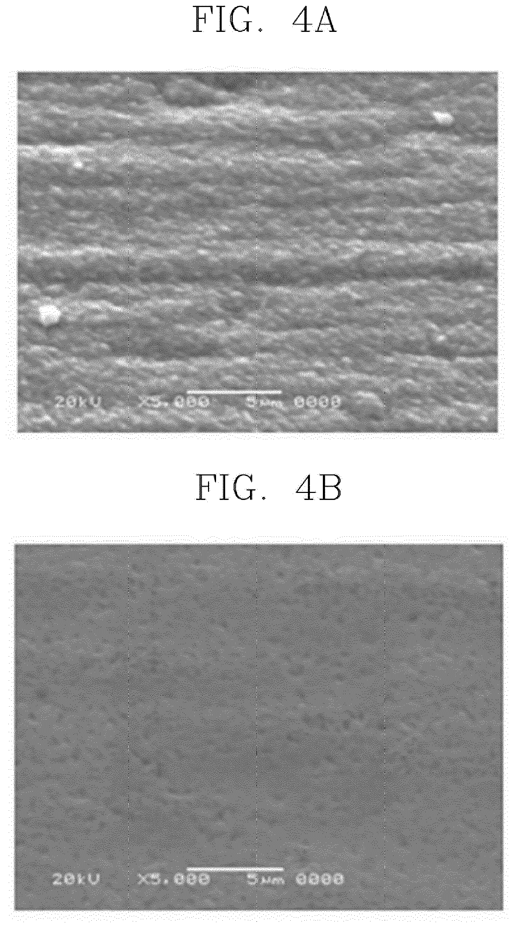

FIGS. 4A to 4C are SEM images of plating surfaces after the formation of the first ultra-thin copper foil layer, etch stop layer, and second ultra-thin copper foil layer in Example 1, respectively.

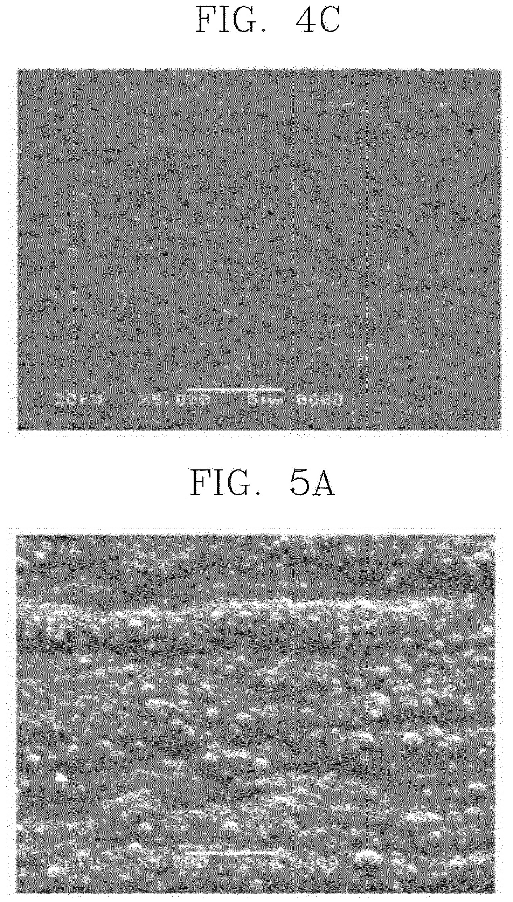

Referring to the drawings, a rough surface condition of the first ultra-thin copper foil layer (FIG. 4A) was changed into a smooth surface condition (FIG. 4B) by the formation of the etch stop layer, resulting in a smooth surface condition of the second ultra-thin copper foil layer (FIG. 4C).

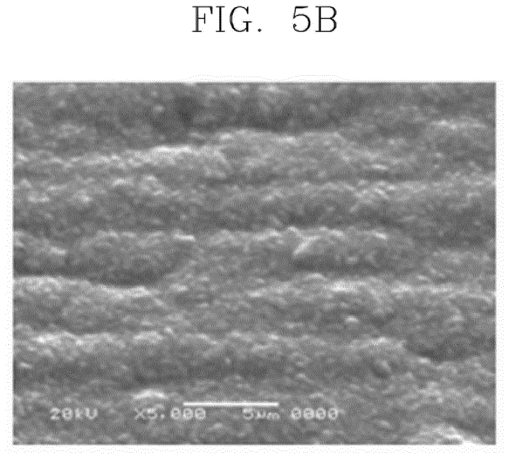

FIGS. 5A and 5B are SEM images of plating surfaces after the formation of the etch stop layer and the second ultra-thin copper foil layer in Comparative Example 1, respectively.

Referring to the drawing, a rough surface of the etch stop layer (FIG. 5A) resulted in a rough surface of the second ultra-thin copper foil layer (FIG. 5B).

## Claims

1. An ultra-thin copper foil with a carrier foil, comprising:
a carrier foil(100);
a non-etching release layer(250) on the carrier foil;
a first ultra-thin copper foil layer(500) on the non-etching release layer;
an etch stop layer(600) on the first ultra-thin copper foil layer; and
a second ultra-thin copper foil layer(700) on the etch stop layer.

2. The ultra-thin copper foil with a carrier foil of claim 1, wherein the etch stop layer(600) has an average roughness Rz of 1.5 µm or less.

3. The ultra-thin copper foil with a carrier foil of claim 1, wherein the etch stop layer(600) has an average roughness Rz of 0.5 µm or less.

4. The ultra-thin copper foil with a carrier foil of claim 1, wherein the second ultra-thin copper foil layer(700) has an average roughness Rz of 1.5 µm or less.

5. The ultra-thin copper foil with a carrier foil of claim 1, wherein the second ultra-thin copper foil layer(700) has an average roughness Rz of 0.6 µm or less.

6. The ultra-thin copper foil with a carrier foil of claim 1, wherein the etch stop layer(600) is a nickel or nickel alloy layer.

7. The ultra-thin copper foil with a carrier foil of claim 1, wherein the first ultra-thin copper foil layer(500) has a thickness of 5 µm or less,
the etch stop layer(600) has a thickness of 1 µm or less, and
the second ultra-thin copper foil layer(700) has a thickness of 5 µm or less.

8. The ultra-thin copper foil with a carrier foil of claim 1, wherein the etch stop layer(600) is inert to an etchant for the second ultra-thin copper foil layer(700).

9. The ultra-thin copper foil with a carrier foil of claim 1, wherein the non-etching release layer(250) contains an inorganic metal or an organic material.

10. The ultra-thin copper foil with a carrier foil of claim 1, wherein the non-etching release layer(250) is composed of an alloy containing a first metal having releasability and at least one metal that assists the facilitation of plating of the first metal.

11. The ultra-thin copper foil with a carrier foil of claim 1, wherein the non-etching release layer(250) further comprises an anti-diffusion layer or anti-oxidation layer containing at least one element selected from the group consisting of Ni, Co, Fe, Cr, Mo, W, Al, and P.

12. A method for manufacturing an embedded substrate, the method comprising:
forming, as for a structure in which a non-etching release layer(250), a first ultra-thin copper foil layer(500), an etch stop layer(600), and a second ultra-thin copper foil layer(700) are sequentially laminated on a carrier foil(100), first metal patterns(810) on the second ultra-thin copper foil layer(700) of the structure;
etching a portion of the second ultra-thin copper foil layer(700), exposed between the first metal patterns(810);
forming a first dielectric layer(820) on the first metal patterns(810);
removing the non-etching release layer(250) and the carrier foil(100) from the structure with the first dielectric layer formed therein;
etching to remove the first ultra-thin copper foil layer(500) exposed by the removal of the non-etching release layer(250) and the carrier foil(100); and
etching to remove the etch stop layer(600) exposed after the removal of the first ultra-thin copper foil layer(500).

13. The method of claim 12, wherein in the removing of the first ultra-thin copper foil layer(500), an etchant having high etch selectivity to the first ultra-thin copper foil layer is used.

14. The method of claim 12, wherein in the removing of the etch stop layer(600), an etchant having high etch selectivity to the etch stop layer(600) is used.
